# EUROPEAN PATENT APPLICATION

(11) **EP 3 002 793 A1**
(43) Date of publication of application: **06.04.2016**
(21) Application number: 15187569.7
(22) Date of filing: 30.09.2015
(51) Int. Cl.: H01L 31/042, H01L 31/068

(54) **SOLAR ENERGY DEVICE**

(30) Priority: 30.09.2014 IT MO20140277
(71) Applicant: Venturelli, Massimo, 41125 Modena (IT)
(72) Inventor: VENTURELLI, Massimo, 41125 MODENA (IT)
(74) Representative: Zoli, Filippo

(57) **Abstract**

A solar energy device (1) comprises at least a support element (2) defining at least a first face (2a) able to support a first group (3) of photovoltaic cells (4) and at least a second face (2b) staggered with respect to the first face (2a) and able to support a second group (5) of photovoltaic cells (4), wherein the cells (4) of the first group (3) are connected together in series, the cells (4) of the second group (5) are connected together in series and wherein the first and second groups (3, 5) comprise the same number of cells (4), where each cell (4) of the first group (3) is connected in parallel to a respective cell (4) of the second group (5)

## Description

The present invention relates to a solar energy device.

The exploitation of solar energy is well-known to produce electricity via the photovoltaic effect which is generated when the solar radiation hits some semiconductor materials such as silicon.

There are numerous applications that exploit this phenomenon to produce electric energy to be used in various ways.

The most commonly used applications include the use of photovoltaic modules connected together so as to form different power systems.

These modules are made up of a set of photovoltaic cells arranged on support elements and directed in such a way as to be exposed to solar radiation.

The photovoltaic cells of the same module are electrically connected in series and in parallel so that the module can provide an electric power which is proportional to the sum of voltages of the cells connected in series and to the sum of currents of the cells connected in parallel.

In particular, the electric power delivered by several cells connected in series is given by the product of the sum of the voltages of each single cell and the current intensity, with the latter having a value equal to minimum current intensity relative to a cell of the series considered.

The electric power delivered by several cells connected in parallel, on the other hand, is given by the product of the sum of current intensity of each single cell and the current voltage, with the latter having a value equal to minimum voltage relative to a cell of the series considered.

The most commonly used photovoltaic modules are substantially flat panels, which can be positioned on surfaces usually exposed to the sun, especially on the roofs of buildings.

The power produced by the photovoltaic modules of known type is significantly linked to the even exposure of the cells they are made of. During the day, in fact, some photovoltaic cells belonging to the same module can be in a situation of shading, thus significantly reducing the power produced.

In particular, the more a cell is shaded the more the emitted electric power is reduced.

In photovoltaic modules it is sufficient that only one cell is shaded to significantly reduce the total power of the whole module.

In this case, in fact, the current intensity which determines the power provided by series of cells will be equal to the current intensity of the shaded cell, i.e. very low or nil. This means that the contribution of the series of cells connected to it will be very low.

A drawback of known photovoltaic modules, therefore, is linked to the reduction of their efficiency due to the shading of the single cells thereof.

Another drawback of known modules is linked to the fact that these are designed to receive only the direct radiation from the sun, not taking advantage of the diffuse or reflected solar radiation that can come from all directions. For this reason, in fact, both in the case of fixed installations and on real solar tracking systems, designed to direct modules and cells so that sunlight is perpendicular to the catchment surface, the modules and respective cells are positioned so as to face direct sunlight.

The main aim of the present invention is to provide a solar energy device which allows to reduce any power loss due to the shading of one or more of its cells. Within this aim, one object of the present invention is to provide a device which allows to exploit solar radiation diffused and reflected from other surfaces.

Yet another object of the present invention is to provide a solar energy device which allows to overcome the mentioned drawbacks of the prior art within the ambit of a simple, rational, easy, effective to use and affordable solution.

The objects stated above are achieved by the present solar energy device having the characteristics of claim 1.

Other characteristics and advantages of the present invention will become better evident from the description of a preferred but not exclusive embodiment of a solar energy device, illustrated by way of an indicative, but non-limiting, example in the accompanying drawings in which:

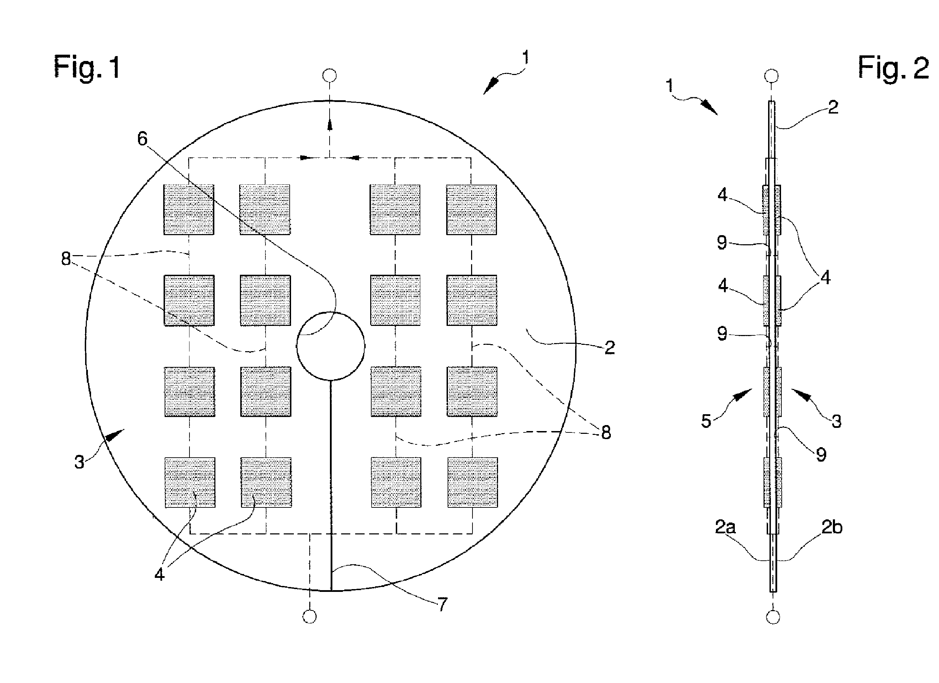

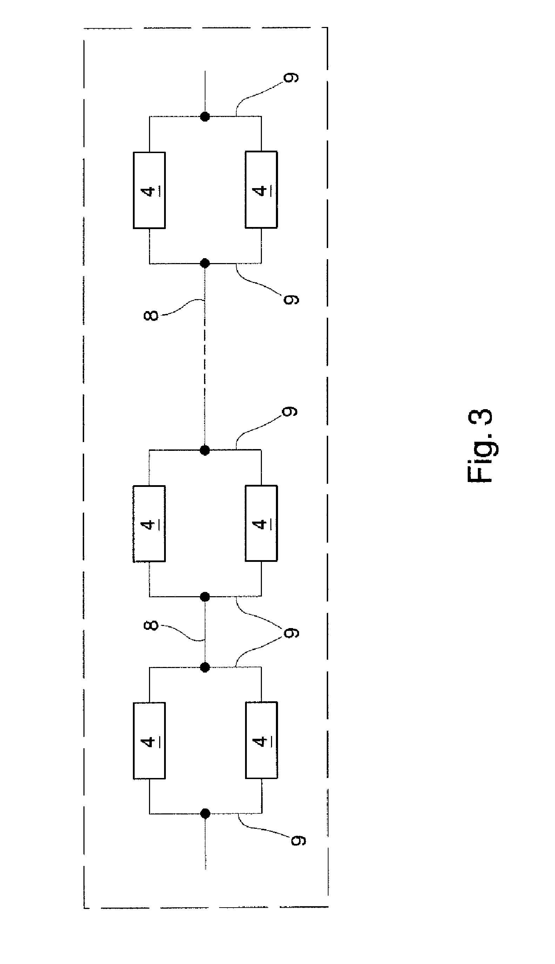

Figure 1 is a front elevation view of a device according to the invention;
Figure 2 is a sectional view of the device of Figure 1.

With particular reference to such figures, reference number 1 globally indicates a solar energy device.

The device 1 comprises at least a support element 2 which has at least a first and a second face, identified with reference numbers 2a and 2b, respectively mutually staggered, i.e. not coplanar.

Preferably, the faces 2a and 2b are mutually opposite and substantially parallel. According to the invention, the device 1 comprises at least a first group 3 of photovoltaic cells 4 associated with the first face 2a and at least a second group 5 of photovoltaic cells 4 associated with the second face 2b.

Conveniently, the device 1 may comprise a plurality of first and second groups 3 and 5.

The cells 4 of the first group 3, as well as the cells 4 of the second group 5, are connected together in series. The cells 4 of the first group 3 are then connected in parallel to the cells 4 of the second group 5.

More particularly, the first and the second group 3 and 5 have the same number of cells 4, wherein each cell 4 of the first group 3 is connected in parallel to a corresponding cell 4 of the second group 5.

The connections in series and in parallel between the various cells 4 are identified in the figures with reference numbers 8 and 9, respectively.

This particular connection between the cells 4 of the first and second group 3 and 5 allows to offset, or at least reduce, the negative effect on the performance of each group 3, 5 due to the shading of one or more of its cells 4.

More in detail, the power reduction generated by one of the two groups 3 and 5 and due to the shading of one or more of its cells 4 can be offset by the power emitted by the cells 4 of the other group 5, 3 connected in parallel to the shaded cells 4 and exposed to diffuse or reflected light.

The support element 2 can have a substantially sheet-like conformation, where the faces 2a and 2b correspond to two opposite faces of the support element itself.

In the preferred embodiment shown in the figures, the support element 2 is of the type insertable in a removable manner within the space interposed between the spokes of a wheel for cycles and motorcycles.

As is known, the wheels of cycles and motorcycles comprise a bearing structure with a hub, a rim intended to support a tire and a plurality of spokes that connect the hub to the rim, of which a first and a second set of spokes which branch off from opposite sides of the hub and converge towards the rim.

The support element 2 is therefore insertable in a removable manner between the first and second spokes of the relative wheel.

More particularly, the support element 2 has a through hole 6 able to be fitted on the hub of the respective cycle or motorcycle and at least a through notch 7 extending from the hole 6 as far as the outer peripheral edge of the support element itself; the notch 7 therefore defines two mutually separate flaps.

In this preferred embodiment, the support element 2 has a substantially circular conformation.

It has in practice been found how the described invention achieves the proposed objects and in particular the fact is underlined that the device according to the invention allows to optimize the performance of a group of cells since the power reduction related to the partial shading of some cells is offset by the power that may come from the cells of another group, connected in parallel to the shaded ones and which are not exposed to direct light but to reflected and diffuse light.

More in detail, in the described invention each single cell has its parallel on the back of the device so as to form, from the electric point of view, a series of double-sided cells. In this manner the catchment surface of each cell can be considered as doubled, with the rear which, in the presence of partial shading, acts as a reliever of current reduction. This effect is reversible so that the series of double-sided cells is always active.

Ultimately, this system of opposing cells is a way to overcome shading and to improve the efficiency of any photovoltaic module.

## Claims

1. Solar energy device (1) comprising at least a support element (2) defining at least a first face (2a) able to support a first group (3) of photovoltaic cells (4) and at least a second face (2b) staggered with respect to said first face (2a) and able to support a second group (5) of photovoltaic cells (4),
**characterized by** the fact that the cells (4) of said first group (3) are connected together in series, that the cells (4) of said second group (5) are connected together in series and by the fact that said first and second groups (3, 5) comprise the same number of cells (4), where each cell (4) of said first group (3) is connected in parallel to a respective cell (4) of said second group (5).

2. Device (1) according to claim 1, **characterized by** the fact that said faces (2a, 2b) are mutually opposite.

3. Device (1) according to one or more of the preceding claims, **characterized by** the fact that it comprises a plurality of said first and second groups (3, 5).

4. Device (1) according to one or more of the preceding claims, **characterized by** the fact that said support element (2) is insertable in a removable manner within the space interposed between the spokes of a wheel for cycles and motorcycles.

5. Device (1) according to claim 4, **characterized by** the fact that said support element (2) has a through hole (6) able to be fitted on the hub of the respective cycle or motorcycle and at least a through notch (7) that extends from said hole (6) as far as the outer peripheral edge of the support element itself, said notch (7) defining two mutually separate flaps.

6. Device according to claim 4 or 5, **characterized by** the fact that said support element (2) has a substantially circular conformation.
